Europäisches Patentamt

European Patent Office

Office européen des brevets

(11) Publication number: **0 090 651**
**B1**

# EUROPEAN PATENT SPECIFICATION

(45) Date of publication of patent specification: **02.11.89**

(51) Int. Cl.⁴: **H 01 L 23/36**, H 01 L 29/06

(21) Application number: **83301771.8**

(22) Date of filing: **29.03.83**

(54) **Semiconductor chip assembly including a thermal radiator plate.**

(30) Priority: **31.03.82 JP 53124/82**

(43) Date of publication of application:
**05.10.83 Bulletin 83/40**

(45) Publication of the grant of the patent:
**02.11.89 Bulletin 89/44**

(84) Designated Contracting States:
**DE FR GB**

(56) References cited:
**CH-A- 384 720**
**FR-A-2 240 530**
**US-A-3 771 028**
**US-A-4 091 408**
**US-A-4 224 734**

(73) Proprietor: **FUJITSU LIMITED**
**1015, Kamikodanaka Nakahara-ku**
**Kawasaki-shi Kanagawa 211 (JP)**

(72) Inventor: **Kashiwagi, Shunji**
**1003-19 Higashihongo-cho Midori-ku**
**Yokohama-shi Kanagawa 226 (JP)**

(74) Representative: **Rackham, Stephen Neil et al**
**GILL JENNINGS & EVERY 53-64 Chancery Lane**
**London WC2A 1HN (GB)**

Courier Press, Leamington Spa, England.

## Description

The present invention relates to the construction of a semiconductor chip assembly which comprises a semiconductor substrate and a metal radiator plate provided on the rear surface of the substrate.

The radiator plate is bonded to the substrate at a high temperature and due to their different coefficients of thermal expansion they contract to different extents on cooling to room temperature which leads to the complete assembly buckling. This may crack the semiconductor substrate and lead to difficulties in handling with, for example, a vacuum chuck. Typically the lower surface of the assembly is convexly curved and this reduces the efficiency of the thermal coupling between the radiator plate and a heat sink. One way of overcoming this problem of the buckling of the assembly is to increase the thickness of the substrate but this reduces the thermal coupling between the active devices on one side of the substrate and the radiator plate on the other side of the substrate.

US—A—40911408 describes a semiconductor chip assembly comprising a semiconductor substrate on one side of which an active region is formed, and a radiator plate which is bonded to the opposite side of the semiconductor substrate, the radiator plate being made of a material having a different co-efficient of heat expansion than the semiconductor substrate, and the semiconductor substrate having a recess formed on the said opposite side of the semiconductor substrate. In the arrangement shown in this specification the substrate includes a number of generally parallel grooves and the heat sink is corrugated to mate with the substrate.

US—A—4224734 is generally similar to the semiconductor chip assembly described above except that it discloses only a single groove extending on the under side of the semiconductor substrate and a heat sink including only a single corrugation mated with the semiconductor substrate.

According to this invention as claimed such a semiconductor chip assembly is arranged so that the entire radiator plate is contained by a recess on the said one side of the substrate and by the thickness of the radiator plate being less than the thickness of the semiconductor substrate outside the recess.

With the semiconductor chip assembly in accordance with this invention the buckling of the chip assembly due to the difference in the coefficients of thermal expansion between the parts is avoided, whilst, at the same time, enhancing the efficiency of heat radiation. Further stable characteristics are obtained, reliable handling of the chip assembly is achieved and cracking of the semiconductor chip is avoided.

Two embodiments of semiconductor chip assemblies in accordance with this invention will now be described and contrasted with the prior art with reference to the accompanying drawings in which:—

Figure 1 is a side elevation of a conventional semiconductor chip assembly;

Figures 2A and 2B are side elevations of the conventional semiconductor chip assembly, showing it buckled;

Figure 3 is a plan of a first embodiment of a semiconductor chip assembly in accordance with the present invention;

Figure 4 is a cross section taken along line II-II shown in Figure 3, and drawn to a larger scale;

Figure 5 is a side elevation partly sectioned taken along line III—III shown in Figure 3, and drawn to a larger scale; and

Figure 6 is a plan of a second embodiment of the semiconductor chip assembly in accordance with the present invention.

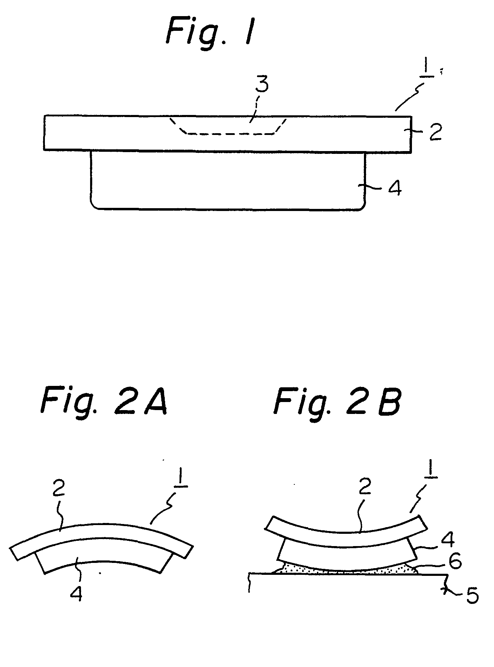

As illustrated in Fig. 1, a metal radiator plate 4 is bonded to the rear surface of the semiconductor substrate of a semiconductor chip which generates a large amount of heat. In Fig. 1, numeral 1 designates a semiconductor chip, numeral 2 designates a semiconductor substrate, numeral 3 designates an active region, and numeral 4 designates a radiator plate. Such a semiconductor chip 1 is housed within a package (not shown) so that it constitutes a semiconductor device.

The radiator plate 4 is bonded to the semiconductor substrate 2 at a high temperature. When the semiconductor substrate 2 is restored to room temperature after bonding, as illustrated in Fig. 2A, the radiator plate and the semiconductor substrate 2 are convexly curved or twisted due to the difference between the coefficient of heat expansion of the radiator plate 4 and that of the semiconductor substrate 2. The semiconductor chip 1 is made of silicon (Si) or gallium-arsenic (GaAs). The coefficient ($\alpha$) of heat expansion of silicon is $2.4 \times 10^{-6}$. The coefficient ($\alpha$) of heat expansion of gallium-arsenic is $6.9 \times 10^{-6}$. The radiator plate 4 is made of copper (Cu) or silver (Ag). The coefficient ($\alpha$) of heat expansion of copper is $16.7 \sim 20 \times 10^{-6}$. The coefficient ($\alpha$) of heat expansion of silver is $19 \sim 20.5 \times 10^{-6}$. Such deformation of the semiconductor chip 1 causes the semiconductor chip 1 to have an unstable characteristic and causes the semiconductor substrate thereof to crack. Furthermore, semiconductor chip 1 cannot be reliably handled with a vacuum chuck since the surface of the semiconductor substrate 2 is curved.

Also, as illustrated in Fig. 2B the semiconductor chip is concavely curved when a heat treatment is carried out to bond the semiconductor chip 1 to the package 5 due to the difference between the coefficient of heat expansion of the semiconductor substrate 2 and that of the radiator plate 4. This hinders tight contact between the semiconductor chip 1 and the package 5 so that the efficiency of heat radiation is degraded. Numeral 6 designates solder for securing the chip 1 to the package 5.

The dimension of a semiconductor chip 1 having a high frequency or high output power is large. The thickness of the semiconductor substrate 2 of such a semiconductor chip 1 should be large from the viewpoint of strength and easy handling of the semiconductor chip 1. However, a thick semiconductor substrate 2 causes degradation of the efficiency of heat radiation. A thin semiconductor substrate 2 is desirable for increasing the output power of the semiconductor chip 1 since generated heat is effectively radiated. However, the aforementioned problem of deformation of the semiconductor chip 1 is remarkable if the semiconductor substrate is thin.

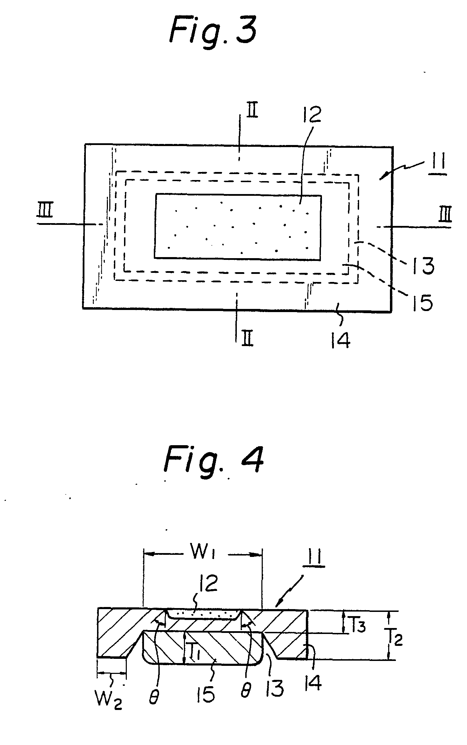

An embodiment of the present invention is illustrated in Figs. 3 to 5. Impurities are diffused in the core portion on the upper main surface of a semiconductor substrate 11 of silicon (Si) or gallium-arsenic (GaAs) so as to form an active region 12.

If the semiconductor chip is a bipolar transistor chip, bipolar transistor of PNP type transistor or NPN type transistor is formed in the active region 12 in which transistor the silicon semiconductor substrate is used as collector region. An overlay type transistor or a mesh emitter type transistor is formed by electrically connecting a plurality of transistor units of such bipolar transistor each other in parallel so as to enhance the output power.

If the semiconductor chip is a MIS type transistor chip or Junction type field effect transistor chip, a field effect transistor of high output power is formed by electrically connecting a plurality of field effect transistor units each other in parallel, in which transistor the silicon semiconductor substrate is used as source region or drain region.

If the semiconductor chip is a Shottky barrier type field effect transistor chip, a field effect transistor of high output power is formed by electrically connecting a plurality of Shottky barrier field effect transistor units each other in parallel in which transistor the active layer is defined by the active region 12 of e.g. N type formed in the semiconductor substrate of Ga-As.

Therefore, if the semiconductor chip is above mentioned bipolar transistor chip, the metal radiator plate constitutes the collector electrode. If the semiconductor chip is above mentioned field effect transistor chip, the metal radiator plate constitutes the source electrode or drain electrode.

A metal electrode layer and an insulation layer are formed on the upper surface of the active region 12 in the semiconductor substrate 11. However, such layers are not illustrated in the drawings.

A rectangular recess 13 is formed on the lower main surface side of the semiconductor substrate 11. The size of the recess 13 corresponds to the size of the active region 12. The recess 13 is defined by a thickened portion 14 formed along all of the edges of the rectangular substrate 11 in order to reinforce the semiconductor substrate. It is preferable that the thickened portion 14 have an inclined inside surface so as to enhance the strength thereof. A radiator plate 15 of metal of high heat conductivity, such as silver (Ag) or copper (Cu), is bonded to the bottom surface of the recess 13 by means of soldering through a thin metallic film (not shown). The width $W_1$ of the radiator plate 15 is determined in such a manner that an end of the radiator plate 15 is located at an angle θ of between 30° and 70°, in which θ is an angle between a line perpendicular to the upper surface of the semiconductor substrate 11 at an end of the active region 12 and a line from the same end of the active region 12 to an end of the radiator plate 15. Generated heat is effectively radiated when the angle θ is between 30° and 70°. It is preferable to determine the length of the radiator plate 15 in the above manner, too.

With the above-mentioned structure of the semiconductor chip, the efficiency of heat radiation can be upgraded by thinning the thickness $T_3$ of the semiconductor susbtrate 11 at a portion of the active region 12 without the occurrence of curving or twisting of the semiconductor chip since the semiconductor substrate 11 is reinforced by the thickened portion 14.

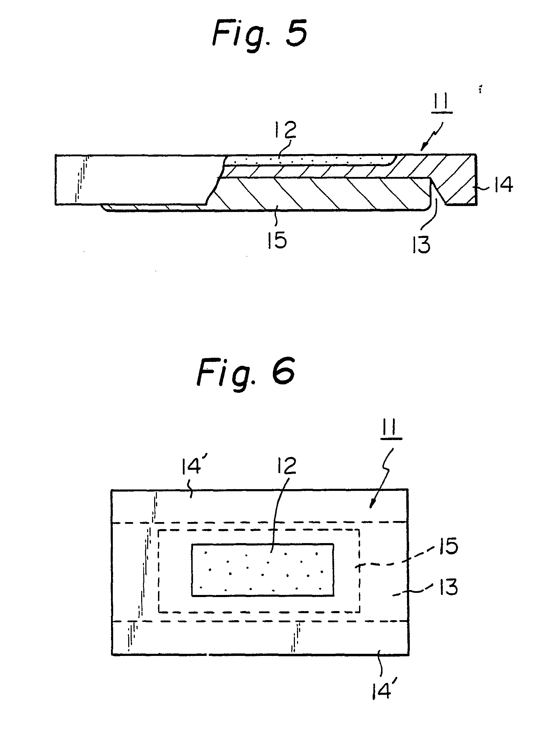

Another embodiment of the present invention is illustrated in Fig. 6. In this embodiment, two thickened portions 14' are formed only along the two longitudinal edges of the semiconductor substrate. This structure can be applied to a semiconductor chip in which the length is sufficiently larger than the width or in which the amount of heat generation is small so that the semiconductor substrate 11 can be thickened while maintaining a heat radiation effect sufficient for the semiconductor chip.

It was confirmed, in an experiment performed by the present inventors, that curving or twisting of a semiconductor chip does not occur according to the present invention. In the experiment; the length of the semiconductor substrate 11 of silicon was 2.2 mm and the width was 1.04 mm; the thickness $T_2$ of the thickened portion thereof was 50 µm; the thickness $T_3$ of the thinned portion thereof was 20 µm; the width $W_2$ of the lower surface of the thickened portion thereof was 100 µm; the active region 12 had a length of 1.8 mm, a width of 0.7 mm, and a depth of 3000 Å; the radiator comprised a silver plate having a length of 1.9 mm, a width of 0.8 mm, and a thickness of 40 µm; the semiconductor chip was treated by a heat treatment at a temperature of about 380°C, which temperature is necessary to bond the radiator plate 15 to the semiconductor substrate 11 and for ohmic contact therebetween; and then the semiconductor chip was restored to room temperature.

Also, it was confirmed that curving or twisting does not occur in a semiconductor chip of the above-mentioned dimension if the semiconductor chip is heated to a temperature of 380°C for soldering on a bonding pad or stage of the package.

In another experiment, the specimen was a semiconductor chip having the structure illustrated in Fig. 6. The semiconductor substrate 11 consisted of silicon and had a length of 2.5 mm, a width of 1.5 mm, a thickness $T_3$ of the thinned portion of 20 µm, and a width $W_2$ of the thickened portion 14' of 300 µm. The experiment was conducted by changing the thickness $T_2$ of the thickened portion 14' and the thickness $T_1$ of the radiator plate 15 of silver under a temperature change of about 400°C. Six specimens were tested in respect to various conditions of $T_1$ and $T_2$.

When $T_2$ was equal to 20 µm (i.e., when $T_2$ was equal to $T_3$) and $T_1$ was equal to about 42 µm, deformation occurred in all of the six specimens.

When $T_2$ was equal to 30 µm and $T_1$ was equal to about 32 µm, deformation occurred in four specimens.

When $T_2$ was equal to 40 µm and $T_1$ was equal to about 38 µm, none of the six specimens was deformed.

When $T_2$ was equal to 50 µm and $T_1$ was equal to about 37 µm, none of the six specimens was deformed.

As is apparent from the above results, deformation of the semiconductor chip is effectively prevented when the thickness $T_1$ of the radiator plate is less than the thickness $T_2$ of the thickened portion of the semiconductor substrate.

## Claims

1. A semiconductor chip assembly comprising a semiconductor substrate (11) on one side of which an active region (12) is formed, and a radiator plate (15) which is bonded to the opposite side of the semiconductor substrate (11), the radiator plate being made of a material having a different coefficient of heat expansion than the semiconductor substrate, and the semiconductor substrate having a recess (13) formed on the said opposite side of the semiconductor substrate (11), characterised in that the entire radiator plate (15) is contained in the recess (13) and in that the thickness (T1) of the radiator plate (15) is less than the thickness (T2) of the semiconductor substrate (11) outside the recess (13).

2. A semiconductor chip assembly according to claim 1, in which the semiconductor substrate (11) consists of silicon or gallium-arsenide.

3. A semiconductor chip assembly according to claims 1 or 2, in which the radiator plate (15) is made from material consisting mainly of copper or silver.

4. A semiconductor chip assembly according to any one of the preceding claims in which the recess (13) is surrounded on all sides by a thick portion (14) of the semiconductor substrate.

5. A semiconductor chip assembly according to any one of claims 1 to 3, in which the semiconductor substrate (11) is of a rectangular shape and in which the recess (13) has two thicker portions (14') of the substrate formed along its two longitudinal edges.

6. A semiconductor chip assembly according to any one of the preceding claims, in which the edges of the recess (13) are inclined.

## Patentansprüche

1. Halbleiterchipanordnung mit einem Halbleitersubstrat (11), auf dessen einer Seite ein aktiver Bereich (12) gebildet ist, und einer Radiatorplatte (15), die an der gegenüberliegenden Seite des Halbleitersubstrats (11) befestigt ist, welche Radiatorplatte aus einem Material besteht, das einen anderen Wärmeausdehnungskoeffizienten als das Halbleitersubstrat hat, und bei der das Halbleitersubstrat eine Ausnehmung (13) hat, die auf der gegenüberliegenden Seite des Halbleitersubstrats ausgebildet ist, dadurch gekennzeichnet, daß die gesamte Radiatorplatte (15) in der Ausnehmung (13) enthalten ist und daß die Dicke (T1) der Radiatorplatte (15) geringer als die Dicke (T2) des Halbleitersubstrats (11) außerhalb der Ausnehmung (13) ist.

2. Halbleiterchipanordnung nach Anspruch 1, bei der das Halbleitersubstrat (11) aus Silicium oder Galliumarsenid besteht.

3. Halbleiterchipanordnung nach Anspruch 1 oder 2, bei der die Radiatorplatte (15) aus einem Material hergestellt ist, welches hauptsächlich aus Kupfer oder Silber besteht.

4. Halbleiterchipanordnung nach einem der vorhergehenden Ansprüche, bei welcher die Ausnehmung (13) an allen Seiten von einem dicken Abschnitt (14) des Halbleitersubstrats umgeben ist.

5. Halbleiterchipanordnung nach einem der Ansprüche 1 bis 3, bei der das Halbleitersubstrat (11) eine rechtwinklige Form hat und bei der die Ausnehmung (13) zwei dickere Abschnitte (14') aus dem Substrat hat, die längs ihren beiden Längsrändern gebildet sind.

6. Halbleiterchipanordnung nach einem der vorhergehenden Ansprüche, bei welcher die Ränder der Ausnehmung (13) geneigt sind.

## Revendications

1. Ensemble à puce semi-conductrice comprenant un substrat semi-conducteur (11) sur une première face duquel est formée une région active (12), et une plaque (15) formant radiateur qui est fixée à la face opposée du substrat semi-conducteur (11), la plaque formant radiateur étant constituée d'un matériau ayant un coefficient de dilatation thermique différent de celui de substrat semiconducteur, et le substrat semi-conducteur ayant une cavité (13) formée à ladite face opposée du substrat (11), caractérisé en ce que la totalité de la plaque (15) formant radiateur est logée dans la cavité (13), et en ce que l'épaisseur ($T_1$) de la plaque (15) formant radiateur est inférieure à l'épaisseur ($T_2$) du substrat semi-conducteur (11) à l'extérieur de la cavité (13).

2. Ensemble à puce semi-conductrice selon la revendication 1, dans lequel le substrat semi-conducteur (11) est formé de silicium ou d'arséniure de gallium.

3. Ensemble à puce semi-conductrice selon la revendication 1 ou 2, dans lequel la plaque (15) formant radiateur est constituée d'un matériau consistant essentiellement en cuivre ou en argent.

4. Ensemble à puce semi-conductrice selon l'une quelconque des revendications précédentes, dans lequel la cavité (13) est entourée de tous côtés par une partie épaisse (14) du substrat semi-conducteur.

5. Ensemble à puce semi-conductrice selon l'une quelconque des revendications 1 à 3, dans lequel le substrat semi-conducteur (11) a une forme rectangulaire, et dans lequel la cavité (13) a deux parties (14') plus épaisses de substrat formées le long de ses deux bords longitudinaux.

6. Ensemble à puce semi-conductrice selon l'une quelconque des revendications précédentes, dans lequel les bords de la cavité (13) sont inclinés.

*Fig. 1*

*Fig. 2 A*

*Fig. 2 B*

# Fig. 3

# Fig. 4

EP 0 090 651 B1

# Fig. 5

# Fig. 6

3